# DEMANDE DE BREVET EUROPEEN

(11) **EP 1 056 200 A1**
(43) Date de publication de la demande: **29.11.2000**
(21) Numéro de dépôt: 00401338.9
(22) Date de dépôt: 16.05.2000
(51) Int. Cl.: H03H 7/38

(54) **Circuit d'adaptation d'impedance pour amplificateur**

(30) Priorité: 28.05.1999 FR 9906794
(71) Demandeur: THOMSON-CSF, 75008 Paris (FR)
(72) Inventeur: Darges, Bernard, 94117 Arcueil Cedex (FR); Prigent, Jean-Paul, 94117 Arcueil Cedex (FR)
(74) Mandataire: Desperrier, Jean-Louis

(57) **Abrégé**

L'invention concerne les circuits d'adaptation d'impédance utilisés pour coupler un amplificateur à sa charge.

Pour avoir une bande de fréquences de fonctionnement de l'ordre de l'octave il est proposé de disposer en parallèle dans les circuits d'adaptation d'impédance, des bras de réactance (Ta-Can Tb-Cb) de type L-C série dont le rôle est d'améliorer, en milieu de bande passante, l'adaptation d'impédance.

Application, en particulier, dans les émetteurs de télévision, à la sortie des amplificateurs de puissance.

## Description

L'invention concerne les circuits d'adaptation d'impédance destinés à être branchés entre un amplificateur et sa charge. Elle a été faite dans le cadre d'études portant sur la réalisation de circuits d'adaptation large bande pour amplificateurs de moyenne et forte puissance, destinés en particulier à toute la bande de la télévision, soit de 470 à 860 MHz ; il s'est avéré que des circuits d'adaptation selon l'invention étaient utilisables même pour des amplificateurs de très faible puissance et cela avec des fréquences de travail s'étendant largement en deçà et au-delà de la bande UHF, c'est-à-dire des ondes décimétriques.

L'utilisation d'un circuit d'adaptation d'impédance entre un amplificateur et sa charge a pour but de chercher à optimiser l'impédance de charge ramenée sur la sortie de l'amplificateur. Avec les circuits connus, dont un exemple sera donné dans ce qui suit, la puissance dissipée dans les composants peut porter ces derniers à des températures qui dépassent les limites prescrites par les fabricants de ces composants ; parallèlement la bande de fonctionnement de ces circuits connus est insuffisante dans certaines applications.

Le but de la présente invention est d'éviter ou pour le moins de réduire les inconvénients des circuits d'adaptation d'impédance connus.

Ceci est obtenu par l'utilisation d'impédances de type L-C série branchées en parallèle dans le circuit d'adaptation.

Selon l'invention il est proposé pour cela un circuit d'adaptation d'impédance destiné à être branché entre un amplificateur et une charge, caractérisé en ce qu'il comporte n, avec n entier positif, circuits en T avec une première et une deuxième branche du T en série entre l'amplificateur et la charge et une troisième branche du T en dérivation et en ce que la troisième branche est constituée par une réactance de type L-C série, pour améliorer, en milieu de bande passante, l'adaptation d'impédance.

La présente invention sera mieux comprise à l'aide de la description ci-après et des figures s'y rapportant qui représentent
- la figure 1, le schéma d'un ensemble amplificateur de sortie - circuit d'adaptation d'impédance - charge, selon l'art connu,
- les figures 2 à 5 des schémas d'ensembles amplificateur de sortie - circuit d'adaptation d'impédance - charge, selon l'invention.

Sur les différentes figures les éléments correspondants sont désignés par les mêmes repères.

Dans ce qui suit les explications seront données relativement à des amplificateurs à sorties symétriques, étant entendu que l'invention s 'applique également aux amplificateurs à deux sorties dont l'une est à la masse, les schémas tels qu'ils sont présentés pouvant être considérés comme une représentation avec son symétrique par rapport à la masse de ce que seraient les schémas avec amplificateurs à deux sorties dont l'une à la masse.

Par ailleurs, sur les dessins, des traits de connexion ont été dessinés qui relient par exemple des lignes imprimées à des sorties d'amplificateurs, à des réactances ; ces traits sont destinés à mieux permettre de distinguer entre les différents éléments du montage mais, en réalité, les connexions sont, partout, de longueur aussi réduite que possible ; c'est ainsi en particulier que les bornes de sortie des amplificateurs sont constituées par des électrodes de transistors sur lesquelles sont directement connectées, donc sans fils de liaison, des bornes d'inductances.

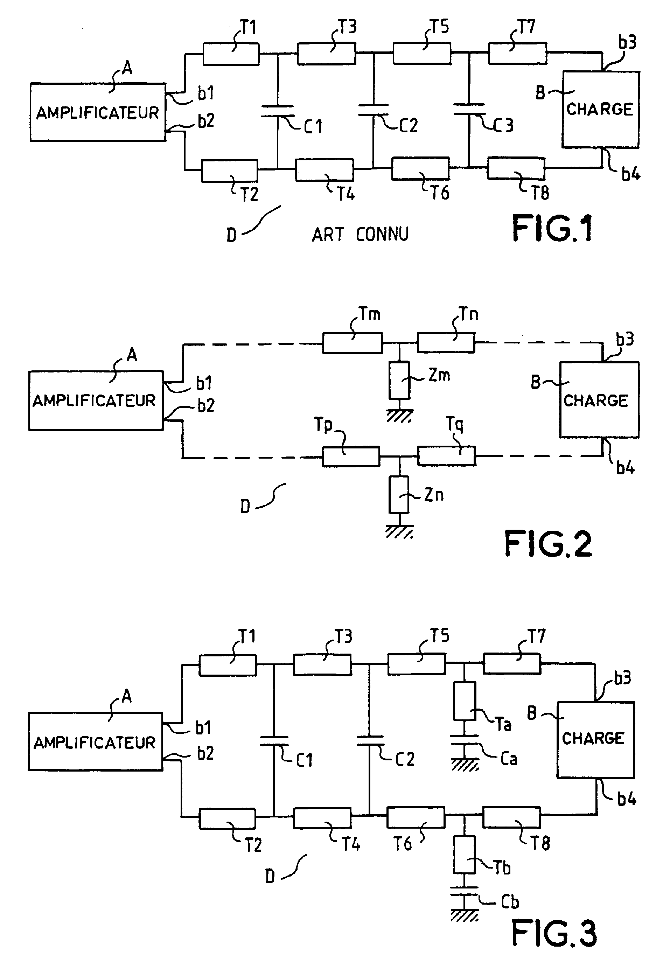

La figure 1 est un schéma d'un ensemble électronique selon l'art connu avec un amplificateur A, dont les bornes de sortie b1, b2 sont couplées aux bornes b3, b4 d'une charge B par un circuit d'adaptation d'impédance, D, qui est un quadripôle dont les accès sont constitués par les bornes b1 à b4, Dans le cadre de l'étude qui a débouché sur les ensembles électroniques qui seront décrits à l'aide des figures 2 et suivantes, l'amplificateur était un amplificateur de 150 W, à sorties symétriques, avec des transistors de sortie en technologie LDMOS, et était destiné à travailler dans la bande UHF. Le circuit D était constitué par huit réactances inductives T1 à T8 et trois condensateurs C1 à C3; les réactances T1, T3, T5, T7 étaient connectées en série entre les bornes b1 et b3, les réactances T2, T4, T6, T8 étaient connectées en série entre les bornes b2 et b4 et les condensateurs C1, C2, C3 et reliaient les points communs de T1-T3, T3-T5 et T5-T7, respectivement aux points communs de T2-T4, T4-T6 et T6-T8. Avec un ensemble électronique selon la figure 1, en ondes décimétriques la bande des fréquences de fonctionnement ne dépassait pas la demi-octave, du fait de la présence du circuit d'adaptation d'impédance.

Afin d'améliorer les performances en ce qui concerne la bande passante et, par là même, réduire la puissance dissipée en radiofréquence dans les composants, l'idée a été de disposer en parallèle dans le circuit d'adaptation d'impédance, des bras de réactance de type L-C série afin d'améliorer l'adaptation d'impédance. Ces bras de réactance étant disposés dans le circuit d'adaptation forment un T avec des réactances inductives série comparables à celles dont il a été question lors de la description de la figure 1 et viennent en remplacement d'au moins un des condensateurs disposés comme les condensateurs C1 à C3 de la figure 1.

La figure 2 est un schéma d'un ensemble électronique selon l'invention, avec un amplificateur A dont les bornes b1, b2 sont respectivement couplées aux premières branches Tm, Tp d'une paire de circuits en T ; les deuxièmes branches Tn, Tq de ces circuits en T sont couplées respectivement aux bornes b3-b4 d'une charge B ; les troisièmes branches Zm, Zn de ces circuits en T sont reliées à la masse.

Dans l'ensemble électronique selon la figure 2 les couplages entre les bornes b1 à b4 et la paire de circuits en T ont été dessinés en traits interrompus pour indiquer que, lors des études qui ont été effectuées, la paire de circuits en T a été disposée en différents endroits dans le circuit d'adaptation D ; voire même plusieurs paires de circuits en T ont été disposées dans le circuit d'adaptation D. Par ailleurs l'étude a été effectuée en veillant à conserver la symétrie du circuit d'adaptation c'est ainsi en particulier que les circuits en T sont identiques. Quant à la troisième des branches des circuits en T, son rôle est d'améliorer l'adaptation au milieu de la bande des fréquences de fonctionnement et, accessoirement, de diminuer les courants dans les condensateurs d'adaptation disposés comme les condensateurs C1 à C3 de la figure 3. Pour cela les troisièmes branches sont constituées par une impédance, Zm, Zn, de type L-C série où la partie inductive est calculée en fonction de l'adaptation à réaliser en milieu de bande et où la partie capacitive, indispensable pour empêcher le passage des courants continus, peut également être prévue pour participer à l'adaptation ; dans le cas où la partie capacitive participe à l'adaptation, le condensateur employé afin de réaliser cette partie capacitive, est de valeur bien inférieure à celle du condensateur utilisé seulement comme condensateur de blocage.

La figure 3 représente un ensemble électronique qui correspond à celui de la figure 1 mais modifié selon l'invention : remplacement du condensateur C3 par deux réactances identiques Ta-Ca, Tb-Cb branchées l'une entre le point commun aux réactances T5, T7 et la masse et l'autre entre le point commun aux réactances T6, T8 et la masse.

Il est à noter que, dans les figures 1 à 3, lorsque les fréquences de fonctionnement sont de l'ordre de 100 à 200 MHz, les réactances inductives telles que T1 à T8, Tm, Tn, Ta, Tb sont des éléments à constantes localisées du type bobine inductive et que les condensateurs sont, eux aussi, à constantes localisées.

A partir de 200 MHz, plus les fréquences de fonctionnement son élevées, plus l'utilisation d'éléments à constantes réparties s'impose pour les réactances inductives telles que T1 à T8, Tm, Tn, Ta, Tb. Dans des ensembles électroniques mis au point lors de l'étude déjà mentionnée, ces réactances inductives sont constituées à l'aide de lignes imprimées réalisées à l'aide de circuits imprimés dont l'une des faces comporte un plan de masse et l'autre une ligne imprimée dont la géométrie est fonction des réactances inductives à obtenir.

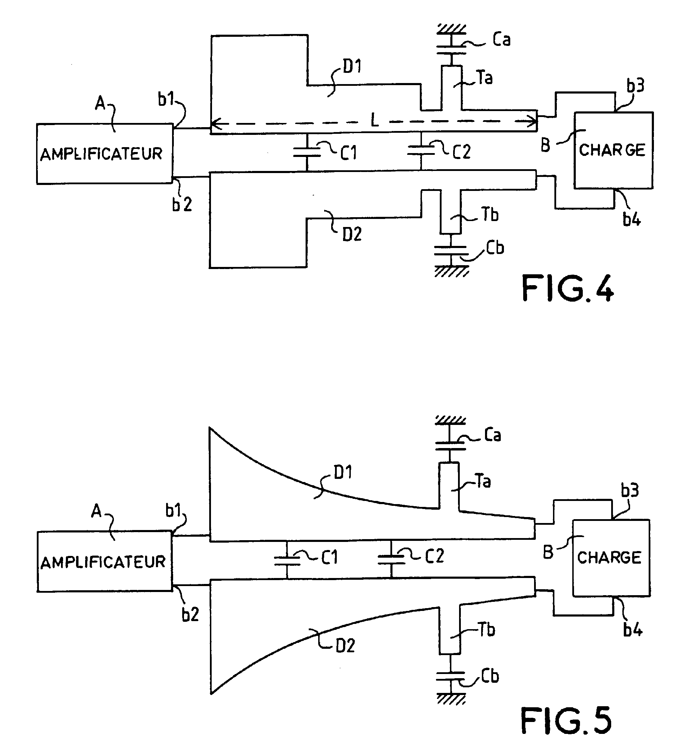

Les figures 4 et 5 sont des schémas d'ensembles électroniques selon l'invention réalisés, pour ce qui est des réactances inductives, avec des lignes imprimées et, pour ce qui est des réactances capacitives, avec des condensateurs à constantes localisées. Ces figures correspondent à la figure 3 mais sont plus proches de la réalité physique pour la représentation des réactances inductives faites de lignes imprimées.

Les figures 4 et 5 se distinguent de la figure 3 par le fait que les inductances T1 à T8 et Ta, Tb sont "agglomérées" en deux lignes imprimées de longueur L et de largeur variable : une première ligne D1 entre la borne b1 de l'amplificateur A et la borne b3 de la charge B et une deuxième ligne, D2, symétrique de la première, entre la borne b2 de l'amplificateur et la borne b4 de la charge.

Les condensateurs C1, C2 de la figure 3 se retrouvent sur les figures 4 et 5 sous la forme de condensateurs à constantes localisées, qui relient entre elles les lignes D1, D2.

Pour ce qui est des réactances inductives Ta, Tb de la figure 3, elles se retrouvent dans les figures 4 et 5 où elles font partie respectivement des lignes D1, D2 sous la forme d'excroissances latérales. Et les condensateurs Ca, Cb sont des condensateurs à constantes localisées, connectés entre les extrémités des excroissances et la masse.

Dans le cas de la figure 4 les lignes D1, D2 sont des lignes où la variation de la largeur de la ligne, d'où résulte l'adaptation d'impédance, se fait par marches successives ; les condensateurs C1, C2 sont disposés au niveau des changements de marche tandis que les réactances Ta-Ca, Tb-Cb sont situées sensiblement aux trois quarts de la longueur L, à partir respectivement des bornes b1, b2 de l'amplificateur A.

Dans le cas de la figure 5, les lignes D1, D2 sont des lignes où la variation de la largeur de la ligne, d'où résulte l'adaptation d'impédance, est une variation en continu ; les condensateurs C1, C2 sont des condensateurs à constantes localisées.

Dans les exemples de réalisation selon les figures 4 et 5, les condensateurs Ca, Cb sont de très faible valeur (3pF), car, en plus de leur rôle de barrière au courant continu, ils participent à l'adaptation d'impédance entre l'alimentation A et la charge B.

Les réalisations qui ont servi d'exemples pour les descriptions selon les figures 4 et 5 ont une bande de fréquences de fonctionnement qui s'étend de 470 MHz à plus de 900 MHz c'est-à-dire qu'ils sont utilisables aussi bien en télévision analogique, en dessous de 700 MHz, qu'en télévision numérique, au-dessus de 700 MHz. A titre de comparaison l'ensemble électronique correspondant, selon l'art connu, c'est-à-dire selon la figure 1 ne permettait même pas de couvrir toutes les fréquences de la télévision analogique.

La présente invention n'est pas limitée aux exemples décrits et concerne en particulier toutes les variantes quant au nombre et à la constitution des réactances en série et en dérivation dans le circuit d'adaptation d'impédance.

L'invention a été conçue dans le domaine de la télévision et concernait la réalisation d'un module de sortie, de forte puissance pour émetteur de télévision.

## Revendications

1. Circuit d'adaptation d'impédance destiné à être branché entre un amplificateur (A) et une charge (B), caractérisé en ce qu'il comporte n, avec n entier positif, circuits en T (Tm-Tn-Zm; Tp-Tq-Zn) avec une première (Tm ; Tp) et une deuxième (Tn ; Tq) branche du T en série entre l'amplificateur et la charge et une troisième (Zm ; Zn) branche du T en dérivation et en ce que la troisième branche est constituée par une réactance (Zm ; Zn) de type L-C série, pour améliorer, en milieu de bande passante, l'adaptation d'impédance.

2. Circuit d'adaptation selon la revendication 1 pour amplificateur à deux sorties symétriques, le circuit comportant un premier (b1) et un deuxième (b2) accès pour être couplé à l'amplificateur, un troisième (b3) et un quatrième (b4) accès pour être couplé à la charge, un premier montage en série (T1, T3, T5, T7) entre le premier et le troisième accès, un second montage en série (T2, T4, T6, T8), symétrique du premier montage, entre le deuxième et le quatrième accès, caractérisé en ce que n est paire et en ce que chaque circuit en T a sa première (T5, T7) et sa deuxième (T6, T8) branche qui font partie de l'un des deux montages série et sa troisième (Zm, Ta-Ca ; Zn, Tb-Cb) branche qui est symétrique de la troisième branche d'un circuit en T de l'autre des deux montages série.

3. Circuit d'adaptation selon la revendication 1 ou 2, destiné à travailler à des fréquences inférieures à 200 MHz, caractérisé en ce que la réactance est constituée par une inductance (Ta ; Tb) de type bobine, en série avec un condensateur (Ca ; Cb) à constantes localisées.

4. Circuit d'adaptation selon la revendication 1 ou 2, destiné à travailler à des fréquences supérieures à 200 MHz, caractérisé en ce que la réactance est constituée par une ligne imprimée (Ta ; Tb) en série avec un condensateur (Ca ; Cb) à constantes localisées.

5. Circuit d'adaptation selon la revendication 4, dans lequel n = 2, caractérisé en ce qu'il comporte une première (D1) et une deuxième (D2) ligne imprimée de longueur L, qui relient respectivement le premier accès (bl) au troisième accès (b3) et le deuxième accès (b2) au quatrième accès (b4) et en ce que les réactances des deux circuits en T ont respectivement deux parties inductives (Ta, Tb) qui font respectivement partie des deux lignes imprimées (D1, D2) dans lesquelles elles constituent des excroissances latérales.

6. Circuit d'adaptation selon la revendication 5, caractérisé en ce que les lignes imprimées (D2, D2) sont des lignes dont la largeur varie en marches d'escalier.

7. Circuit d'adaptation selon la revendication 5, caractérisé en ce que les lignes imprimées (D1, D2) sont des lignes dont la largeur varie en continu.
